# EUROPÄISCHE PATENTSCHRIFT

(11) **EP 1 313 897 B1**
(45) Veröffentlichungstag und Bekanntmachung des Hinweises auf die Patenterteilung: **03.01.2007**
(21) Anmeldenummer: 01957962.2
(22) Anmeldetag: 13.07.2001
(51) Int. Cl.: C30B 25/14, C23C 16/44

(54) **VORRICHTUNG UND VERFAHREN ZUM ABSCHEIDEN INSBESONDERE KRISTALLINER SCHICHTEN AUF INSBESONDERE KRISTALLINEN SUBSTRATEN**
DEVICE AND METHOD FOR THE DEPOSITION OF, IN PARTICULAR, CRYSTALLINE LAYERS ON, IN PARTICULAR, CRYSTALLINE SUBSTRATES
DISPOSITIF DE DEPOSITION, NOTAMMENT DE COUCHES CRISTALLINES SUR, NOTAMMENT, DES SUBSTRATS CRISTALLINS

(30) Priorität: 01.09.2000 DE 10043601
(43) Veröffentlichungstag der Anmeldung: 28.05.2003
(73) Patentinhaber: Aixtron AG, 52072 Aachen (DE)
(72) Erfinder: JÜRGENSEN, Holger, 52072 Aachen (DE); STRAUCH, Gerd, 52072 Aachen (DE); KÄPPELER, Johannes, 52146 Würselen (DE)
(74) Vertreter: Grundmann, Dirk
(86) Internationale Anmeldenummer: PCT/EP2001/008105
(87) Internationale Veröffentlichungsnummer: WO 2002/018680

(56) Entgegenhaltungen:
- WO-A-99/43874
- GB-A- 2 312 990
- US-A- 4 961 399
- US-A- 5 453 124
- US-A- 5 788 777
- US-A- 6 039 812
- PATENT ABSTRACTS OF JAPAN vol. 010, no. 292 (C-376), 3. Oktober 1986 (1986-10-03) & JP 61 110767 A (FUJITSU LTD), 29. Mai 1986 (1986-05-29)

## Beschreibung

Die Erfindung betrifft zunächst eine Vorrichtung zum Abscheiden insbesondere kristalliner Schichten auf einem oder mehreren, insbesondere ebenfalls kristallinen Substraten in einer Prozesskammer mittels in die Prozesskammer eingeleiteten und sich dort pyrolytisch umsetzenden Reaktionsgasen, wobei die Prozesskammer eine erste Wand und eine der ersten gegenüberliegenden, zweite Wand besitzt und der ersten Wand mindestens ein beheizter Substrathalter zugeordnet ist, wobei zumindest ein Reaktionsgas mittels eines flüssigkeitsgekühlten Gaseinlassorgans der Prozesskammer zugeführt wird.

Die Erfindung betrifft ferner ein Verfahren zum Abscheiden insbesondere kristalliner Schichten auf einem oder mehreren, insbesondere ebenfalls kristallinen Substraten in einer Prozesskammer mittels in die Prozesskammer eingeleiteten und sich dort pyrolytisch umsetzenden Reaktionsgasen, wobei die Prozesskammer eine erste Wand und eine der ersten gegenüberliegende, zweite Wand besitzt und auf einem der ersten Wand zugeordneten beheizten Substrathalter ein Substrat liegt.

Eine Vorrichtung der eingangs beschriebenen Art ist aus der US 5,453,124 vorbekannt. Die Prozesskammer wird durch zwei Wände begrenzt. Eine Wand bildet die Basisfläche eines Gaseinlassorgans und verläuft parallel zur anderen Wand. Diese Basisfläche besitzt eine Vielzahl von Gasaustrittsöffnungen. Rückwärtig der Gasaustrittsöffnungen befinden sich Gasverteilkammern, in die Gaszuleitungen münden. Rückwärtig der Gasverteilkammern befindet sich eine Höhlung zur Aufnahme von Kühlwasser.

Bei der Vorrichtung, die die US 4,961,399 beschreibt, wird die erste Wand von einer in der Horizontalebene liegenden Trägerplatte ausgebildet, auf welcher Substrathalter derart angeordnet und gelagert sind, dass diese sich beim Betrieb der Vorrichtung drehen. Die bekannte Vorrichtung besitzt ein zentrales Gaseinlassorgan, durch welches die Reaktionsgase in die Prozesskammer eingeleitet werden. Die dort beschriebene Vorrichtung dient zur Abscheidung von III-IV-Halbleiterschichten. Als Reaktionsgase erwähnt diese Schrift Arsin und Trimethylindium.

Die US-Patent Schrift 5,788,777 beschreibt ebenfalls eine Vorrichtung zum Abscheiden kristalliner Schichten auf kristallinen Substraten in einer Prozesskammer. Dort werden Silan und Propan als reaktive Gase der Prozesskammer durch ein zentrales Gaseinlassorgan zugeführt. Diese Vorrichtung dient zum Abscheiden Siliciumcarbidschichten auf einkristallinen Siliciumsubstraten. Bei den beschriebenen Vorrichtungen bzw. bei den mit der Vorrichtungen ausgeübten Verfahren muss das Problem bewältigt werden, dass Silan bei relativ geringen Temperaturen (etwa 500°C), zerfällt und die Zerfallsprodukte bei diesen Temperaturen nicht gasförmig bleiben, sondern auskondensieren. Das Auskondensieren wird zudem durch die Anwesenheit von Propan und dessen Zerfallsprodukte nachteilhaft beeinflusst.

In dem von der Erfindern dieser Anmeldung stammenden Dokument WO-A-01/14619, Veröffentlicht am 01.03.2001 und angemeldet am 24.08.2000, wird vorgeschlagen durch Einleiten von weit unter Prozesstemperatur gekühlten Prozess- und Trägergas kurz vor dem heißen Substrat, eine vorzeitige Zerlegung von Quellgasen und die lokale Übersättigung des Gasstromes mit Zerlegungsprodukten zu vermeiden.

Der Erfindung liegt die Aufgabe zugrunde, Maßnahmen vorzuschlagen, die das Auskondensieren von Zerfallsprodukten im Gaseinlassbereich verhindern.

Gelöst wird die Aufgabe durch die in den Ansprüchen angegebene Erfindung.

Der Anspruch 1 bildet die gattungsgemäße Vorrichtung dahingehend weiter, dass das Gaseinlassorgan flüssigkeitsgekühlt ist. Gemäß Anspruch 2 wird das Verfahren so geführt, dass zwei Reaktionsgase räumlich beabstandet und unterhalb ihrer Zerlegungstemperaturen gekühlt der Prozesskammer zugeleitet werden, wobei die Temperatur am Ort des Zusammentreffens der beiden Reaktionsgase in der Prozesskammer höher ist, als die Sättigungstemperatur der Zerfallsprodukte bzw. möglicher Addukte der Zerfallsprodukte. Als Reaktionsgase werden bevorzugt Silan und Methan oder Propan verwendet, die durch jeweils gekühlte Zuleitungen bis in die heiße Zone der Prozesskammer geleitet werden. Dies kann zusammen mit einem Trägergas, beispielsweise Wasserstoff erfolgen. Da die gekühlten Zuleitungen bis nahe an die heißen Flächen der Prozesskammer reichen, erwärmen sich die Reaktionsgase sprunghaft. Die Zerlegungsprodukte von Silan, Siliciumatome und die Zerlegungsprodukte von Methan/Propan, Kohlenstoffatome finden demzufolge nahezu sofort nach ihrer Zerlegung eine Umgebung vor, die eine Temperatur aufweist, die oberhalb der Sättigungstemperatur liegt. Es tritt dann so gut wie keine lokale Übersättigung mehr auf. Die Zerfallsprodukte können durch den Gasstrom radial auswärts bis zu den, in bekannter Weise drehangetriebenen Substrathaltern transportiert werden und dort unter Ausbildung einer SiC-Einkristallschicht auf den Substraten wachsen. Das Trägergas sowie nicht kondensierte Reaktionsprodukte werden durch Austrittsöffnungen eines Gasauslassringes abgeführt. Der Prozess kann bei Niedrigdruck (etwa 100 mbar) stattfinden. Durch Wahl geeigneter Prozessparameter sind Wachstumsraten von 10µm/h oder mehr erreichbar. Das Zuleitungsorgan wird mittels Wasser oder einer anderen geeigneten Kühlflüssigkeit gekühlt ist. Ein eine Kühlwasserkammer aufweisender Abschnitt des Zuleitungsorgans kann dabei bis in die heiße Prozesskammer ragen. Ein Reaktionsgas, vorzugsweise Silan, kann aus einem wandgekühlten, ringförmigen Keilspalt austreten. Die Spaltwände bestehen aus Stahl. Der Keilspalt liegt unmittelbar benachbart zu einer auf über 1000°C, bevorzugt über 1500°C heißen Grafit-Wandung der Prozesskammer. Der Keilspalt ist über einen sehr schmalen Ringspalt mit einer Ringkammer verbunden, die sich im Gaseinlassorgan befindet. In diese Ringkammer mündet eine Zuleitung von außerhalb. Dies hat zur Folge, dass das Gas in Umfangsrichtung nahezu gleichverteilt durch den Spalt strömt und in Radialrichtung gleichmäßig austritt. Das andere Reaktionsgas, vorzugsweise Methan oder Propan verlässt den in die Prozesskammer ragenden Abschnitt des Zuleitungsorganes durch eine zentrale Öffnung, die das Ende einer zentralen Zuleitung ist. Diese Öffnung liegt auf einer Basisfläche des in die Prozesskammer ragenden kegelstumpfförmigen Abschnitts. Die Basisfläche liegt etwa mittig zwischen den beiden beheizten Wänden. Der kegelstumpfförmige Abschnitt ist nahezu vollständig hohl. In der Höhlung befindet sich das Kühlwasser, welches mittels Kühlwasserleitblechen durch die Höhlung geleitet wird. In dem Gaseinlassorgan ist eine Zuleitung und eine Ableitung für das Kühlwasser vorgesehen. Auf der Außenwandung des Gaseinlassorganes sitzt ein ringförmiger Träger, welcher eine radial abragende Tragschulter bildet. Der Träger ist vorzugsweise aus Grafit. Auf dieser ringförmigen Tragschulter stützt sich die Deckplatte ab, die rückwärtig insbesondere mittels einer Hochfrequenz-Spule beheizt wird. Zwischen der Deckplatte und dem insgesamt zylinderförmigen Zuleitungsorgan kann noch eine Isoliermanschette liegen, die aus einem Kohlenstoffschaum besteht. Zwischen der Aussenwandung, auf der der Träger sitzt, und der anderen Keilspaltwand befindet sich ebenfalls eine KÜhlwasserkammer.

Die Erfindung betrifft ferner eine Weiterbildung der aus der US 57 88 777 grundsätzlich schon bekannten Deckplatte und deren Halterung am Gaseinlassorgan. Die Epitaxie von SiC mit den Reaktionsgasen Silan und Methan/Propan erfordert eine innerte Beschichtung von sowohl der aus Grafit bestehenden Trägerplatte als auch der ebenfalls aus Grafit bestehenden Deckplatte. Die Beschichtung kann aus TaC oder SiC bestehen. Auch derartig beschichtete Deck- oder Trägerplatten unterliegen aber einem Verschleiß, da die Reaktionsgase eine ätzende wirkung entfalten. Erfindungsgemäß wird die Deckplatte mit austauschbaren Verkleidungsringen verkleidet, welche aus TaC bestehen können. Die Verkleidungsringe halten sich durch gegenseitigen Untergriff und tragen die Deckplatte. Der innenliegende Ring liegt mit seinem inneren Rand auf der Tragschulter des Trägers. In einer Variante der Erfindung ist vorgesehen, dass die Verkleidungsringe aus Grafit bestehen und mit TaC oder SiC beschichtet sind.

In einer bevorzugten Ausgestaltung der Erfindung sitzt die Deckplatte der Prozesskammer fest am Deckel des Reaktorgehäuses. Zwischen dem Reaktorgehäusedeckel und der Deckplatte liegt die ebenfalls fest mit dem Deckel verbundene HF-Spule. Wird der Deckel zum Beladen oder Entladen der Prozesskammer mit Substraten angehoben, was mit geeigneten Pneumatikzylinder erfolgen kann, so heben sich HF-Spule und Prozesskammerdeckplatte mit an.

Die Beheizung der Trägerplatte erfolgt von unten ebenfalls mit einer HF-Spule. Die beiden HF-Spulen können von getrennten HF-Generatoren gespeist werden. Hierdurch ist eine individuelle Regelung von Substrattemperatur und Deckentemperatur möglich. Die Substrattemperatur liegt etwa bei 1600°C. Hierzu wird die vorzugsweise aus Grafit bestehende Trägerplatte auf eine Temperatur von 1700°C bis 1800°C aufgeheizt. Die Oberflächentemperatur der aus Grafit bestehenden Deckplatte liegt etwa bei 1600°C. Auch der Bereich der Deckplatte, der unmittelbar an das Gaseinlassorgan angrenzt, besitzt eine derart hohe Temperatur. Zufolge der Kühlung besitzt das Gaseinlassorgan eine Temperatur von unter 100°C.

Ein Ausführungsbeispiel der Erfindung wird nachfolgend anhand beigefügter Zeichnungen erläutert. Es zeigen:

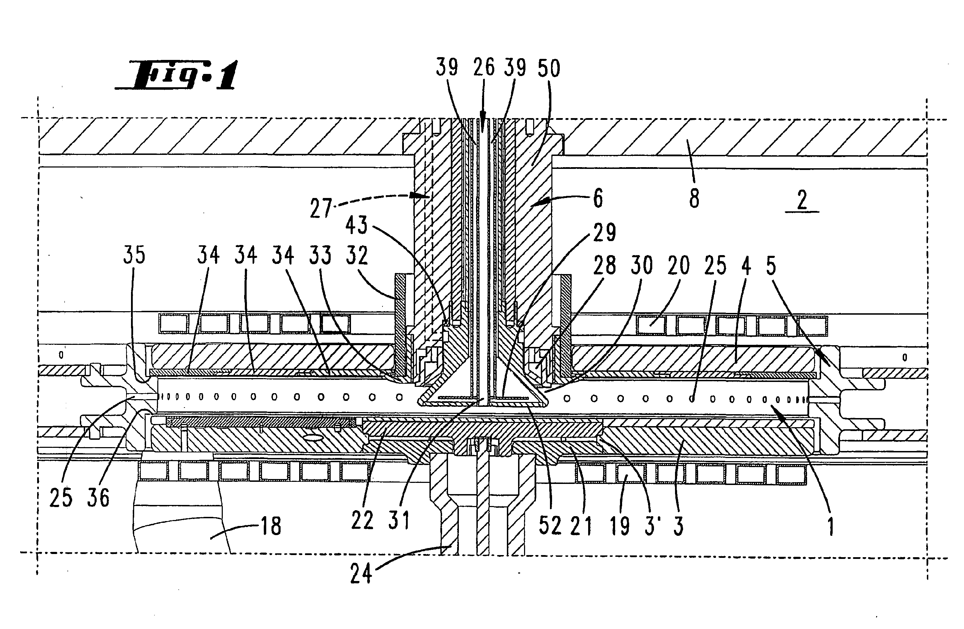

- Fig. 1: in schematischer Darstellung den Reaktor, bestehend aus der in dem Reaktorgehäuse angeordneten Prozesskammer,

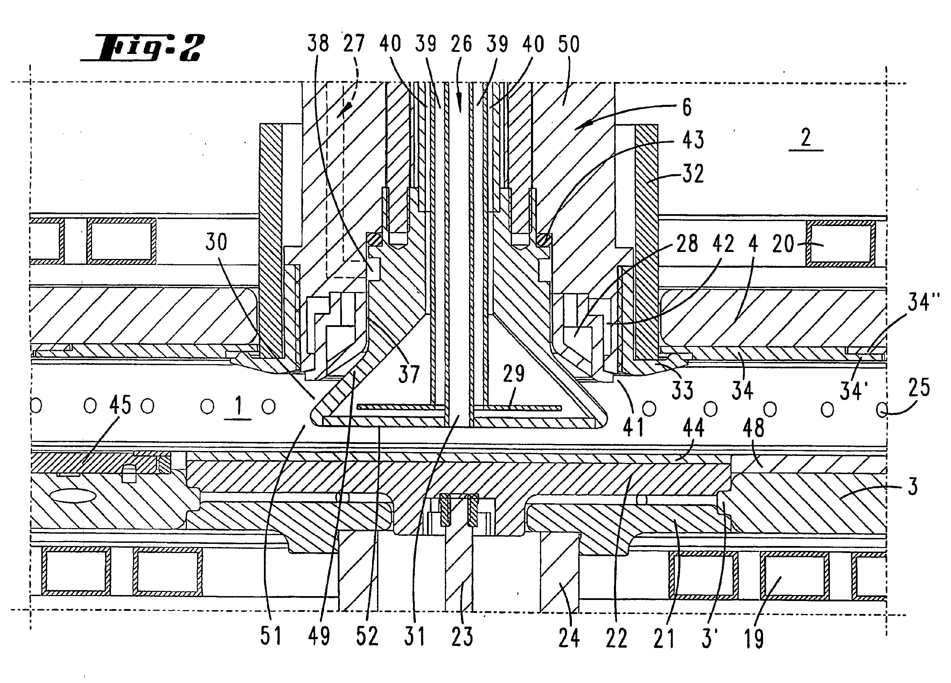

- Fig. 2: eine nochmalige Vergrößerung eines Ausschnittes der Prozesskammer mit Gaseinlassorgan,

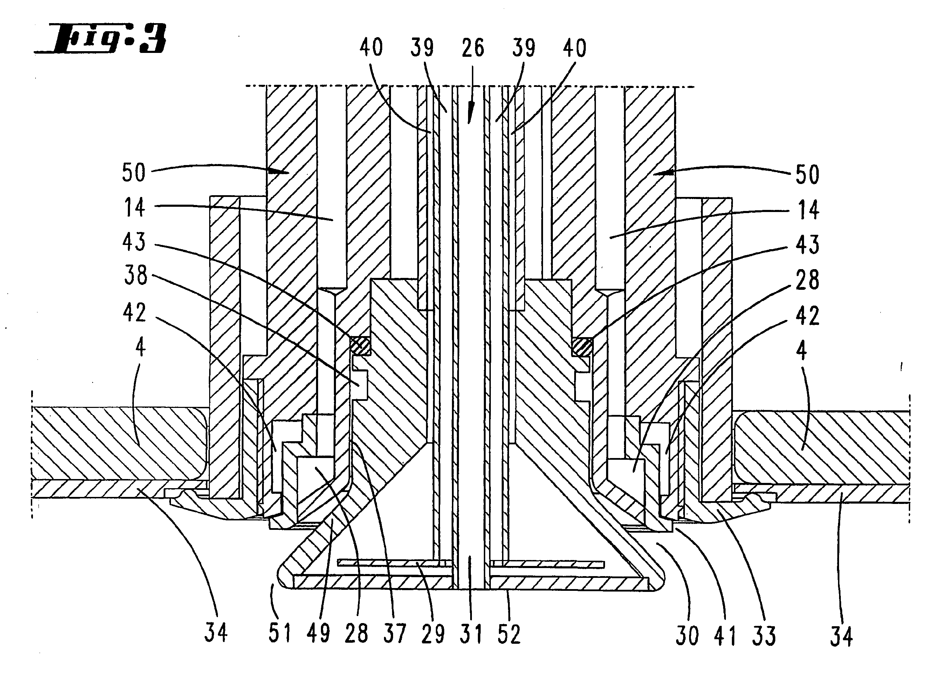

- Fig. 3: eine Darstellung des Gaseinlassorganes gemäß Figur 2 mit geänderter Schnittlinie durch das Gaseinlassorgan und

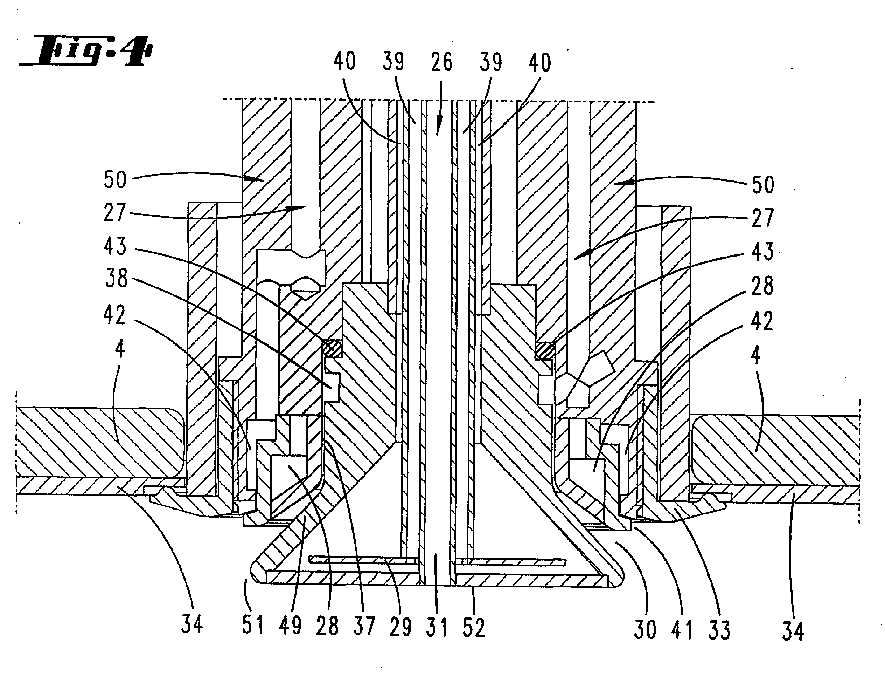

- Fig. 4: eine weitere Darstellung gemäß Figur 2 mit nochmals geänderter Schnittlinie.

Die im Ausführungsbeispiel dargestellte Vorrichtung dient zum monokristallinen Abscheiden von SiC-Schichten auf monokristallinen Si-Substraten in einem Heißwandreaktor. Diese Substrate können einen Durchmesser von 4 Zoll besitzen. Die Vorrichtung befindet sich in einem in den Zeichnungen nicht dargestellten Gehäuse. Der Deckel 8 des Reaktorgehäuses 2 ist nach oben öffenbar. Dabei hebt sich der Deckel 8 zusammen mit einem am Deckel befestigten Gaseinlassorgan 6, einer ebenfalls befestigten Hochfrequenzspule 19 und einer am Gaseinlassorgan 6 befestigten Deckplatte 4 ab. Des Weiteren hebt sich auch noch ein oberer Gehäusewandabschnitt, welcher mit Dichtungen auf einem unteren Gehäusewandabschnitt aufliegt, mit ab, so dass die von der Trägerplatte 3 getragenen Substrathalter 45 mit Substraten belegt werden können.

In dem Reaktorgehäuse 2 befindet sich die Prozesskammer 1. Diese Prozesskammer 1 besitzt eine Trägerplatte 3, die die Substrathalter 45 trägt. Parallel zur Trägerplatte 3 erstreckt sich oberhalb dieser eine Deckplatte 4. Die Trägerplatte 3 wird von unten mittels einer wassergekühlten HF-Spule 19 beheizt. Die Deckplatte 4 wird von oben mit einer ebenfalls wassergekühlten HF-Spule 20 beheizt. Die Trägerplatte 3 ist ringförmig gestaltet, wobei der Außendurchmesser etwa doppelt so groß ist wie der Innendurchmesser. Die Innenwandung der Trägerplatte 3 besitzt eine radial einwärts ragende Ringstufe 3'. Mit dieser Ringstufe 3' liegt die Trägerplatte 3 auf dem Rand einer Stützplatte 21 auf. Die Stützplatte 21 stützt sich wiederum auf einem Stützrohr 24 ab, welches von einer Zugstange 23 durchragt wird. Die Zugstange 23 greift etwa mittig an einer oberhalb der Stützplatte 21 angeordneten Zugplatte 22 an, welche mit ihrem Rand auf die Ringstufe 3' aufliegt. Durch Zug an der Zugstange 23 von unten wird die Trägerplatte 3 klemmbackenartig gehalten.

Die Trägerplatte 3 und die Deckplatte 4 werden von einem Gasauslassring 5 umgeben. Dieser Gasauslassring 5 bildet die seitliche Prozesskammer-Wand. Der Gasauslassring 5 besitzt eine Vielzahl von radialen Bohrungen 25, durch welche das Prozessgas austreten kann. Der Gasauslassring 5 ist ebenso wie die Stützplatte 21, die Zugplatte 22, die Trägerplatte 3 und die Deckplatte 4 aus massivem Grafit gefertigt. Er ist einstückig und hat eine Breite, die etwa der Höhe der Prozesskammer 1 entspricht. Hierdurch besitzt der Gasauslassring 5 eine relativ hohe Wärmekapazität, was zur Folge hat, dass das Temperaturprofil innerhalb der Prozesskammer auch am Rand sehr homogen ist. Indem der Gasauslassring 5 eine von der Deckplatte 4 überfangene Stufe 35 und eine von der Trägerplatte unterfangene Stufe 36 ausbildet, ragt er bereichsweise in den Zwischenraum von Deckplatte 4 und Trägerplatte 3.

Die Deckplatte 4 ist an ihrer Unterseite mit insgesamt drei Verkleidungsringen 34 ausgefüttert. Diese Verkleidungsringe können aus Grafit bestehen oder aus TaC. Sie werden ähnlich wie Ofenringe durch gegenseitigen Übergriff aneinander gehalten, wobei sich der innerste Ring 34 auf einen Ringkragen eines Grafitträgers 33 abstützt, welcher auf das untere Ende des Gaseinlassorganes 6 aufgeschraubt ist. Im Bereich des Übereinanderliegens sind die Verkleidungsringe 34 gefalzt. Sie bilden übereinanderliegende gestufte Ringabschnitte 34', 34" aus, so dass ihre Oberfläche stufenlos verläuft.

Das Gaseinlassorgan 6 ist insgesamt zweiteilig ausgebildet. Es besitzt einen Kern, der einen in die Prozesskammer 1 ragenden Abschnitt 49 ausbildet, welche eine Kegelstumpfgestalt besitzt. Dieser Kern wird von einem Mantel 50 umgeben. Mittels O-Ringdichtung 43 ist der Mantel 50 gegenüber dem Kern 49 abgedichtet.

Die Zuführung des Silans erfolgt durch die Zuleitung 27 welche in eine Ringkammer 38 mündet. An die Ringkammer 38 schließt sich ein Ringspalt 37 an, und an den Ringspalt 37 schließt sich eine ringkeilförmige Öffnung 30 an, durch welche das Silan austritt. Die Wandung dieser Öffnung 30 wird einerseits vom Kernabschnitt 49 und andererseits vom Mantel 50 ausgebildet. Die Wände des Kanals 30 sind gekühlt. Hinter den Kanalwänden befinden sich Kühlwasserkammern 28, durch welche Kühlwasser strömt, um die Wandungstemperatur unterhalb der Zerlegungstemperatur des Silans zu halten.

Das Kühlwasser tritt durch den Kühlwasserkanal 39 in die dem Kern 49 zugeordnete Kühlwasserkammer 28 ein und wird dort mittels Leitblechen 29 an der Wand entlanggeführt, um die Kühlwasserkammer 28 durch den Kanal 40 wieder zu verlassen.

Die Basisfläche 52 welche ebenfalls zufolge rückwärtiger Kühlwasserbeaufschlagung bei einer Temperatur gehalten ist, bei welcher sich die Reaktionsgase nicht zerlegen, befindet sich etwa in der Mitte der Prozesskammer und verläuft parallel zur Oberfläche der Trägerplatte 3. Sie hat einen kleineren Abstand zur Oberfläche der Trägerplatte, als die Hälfte des Abstandes von Deckplatte 4 zu Trägerplatte 3. In der Mitte der Basisfläche 52 befindet sich die Öffnung 31 der Methan- bzw. Propan-Zuleitung 26. Durch einen Spülkanal 41 kann Wasserstoff in die Prozesskammer 1 eintreten. Die Prozessgase werden ebenfalls zusammen mit Wasserstoff durch die ihnen zugeordneten Zuleitungen 26,27 geleitet.

Um die beim Betrieb der Vorrichtung etwa bis auf 1600°C aufgeheizte Deckplatte 4 von dem gekühlten Gaseinlassorgan 6 zu isolieren, ist eine das Gaseinlassorgan umgebende Isolationsmanschette 32 aus einem Kohlenstoffschaum vorgesehen, welche auf dem Träger 33 sitzt.

Mit der Bezugsziffer 51 ist beispielhaft ein Ort in der Prozesskammer 1 dargestellt, wo die Zerlegungsprodukte des Silans mit dessen Methans bzw. Propans zusammentreffen. An diesem Punkt 51 ist die Gas-Temperatur höher als die Sättigungstemperatur der Zerfallskomponenten, so dass keine Übersättigungseffekte auftreten.

Die Trägerplatte 3 wird über das Stützrohr 24 drehangetrieben und trägt drehangetriebene Substrathalter 45. Die Bereiche zwischen den Substrathalter 45 werden von Kompensationsplatten 48 ausgefüllt. Diese liegen lose auf der Oberfläche der Trägerplatte 3 auf. Die Oberflächen von Substrathalter 45 und Kompensationsplatte 48 fluchten zueinander. Die Kompensationsplatten 48 sind vorzugsweise aus TaC gefertigt und austauschbar.

Wird die Trägerplatte 3 von unten beheizt, so tritt im Bereich der Horizontalfuge zwischen Kompensationsplatte 48 und Trägerplatte 3 etwa der gleiche Temperatursprung auf, wie an der Horizontalfuge zwischen Substrathalter 45 und Trägerplatte 3.

Der Mantel 50 besitzt mehrere in axialer Richtung sich erstreckende Bohrungen. Ein oder mehrere Bohrungen 27 dienen der Silanzuführung münden in die Ringkammer 38. Ein oder mehrere weitere Bohrungen dienen der Wasserstoffzuleitung und münden in einem Ringkanal 42, der verbunden ist mit einer ringförmigen Spülgasaustrittsdüse 41.

Parallel zu den Kanälen 27 laufen Kühlwasserzuführ- bzw. Abführkanäle 14. Diese münden in Kühlwasserkammern 28.

## Patentansprüche

1. Vorrichtung zum Abscheiden insbesondere kristalliner Schichten auf einem oder mehreren, insbesondere ebenfalls kristallinen Substraten in einer Prozesskammer (1) mittels in die Prozesskammer eingeleiteten und sich dort pyrolytisch umsetzenden Reaktionsgasen, wobei die Prozesskammer (1) eine erste Wand (3) und eine der ersten gegenüberliegenden, zweite Wand (4) besitzt und der ersten Wand mindestens ein beheizter Substrathalter (45) zugeordnet ist, wobei zumindest ein Reaktionsgas mittels eines flüssigkeitsgekühlten Gaseinlassorgans (6) der Prozesskammer (1) zugeführt wird, wobei das Gaseinlassorgan (6) eine zur ersten Wand (3) parallel verlaufende Basisfläche (52) mit einer Austrittsöffnung (31) aufweist, **gekennzeichnet durch** eine rückwärtig kühlwasserbeaufschlagte Basisfläche (52).

2. Verfahren zum Abscheiden insbesondere kristalliner Schichten auf einem oder mehreren, insbesondere ebenfalls kristallinen Substraten in einer Prozesskammer (1) mittels in die Prozesskammer (1) eingeleiteten und sich dort pyrolytisch umsetzenden Reaktionsgasen, wobei die Prozesskammer eine erste Wand (3) und eine der ersten gegenüberliegenden zweiten Wand (4) besitzt und auf einem der ersten Wand zugeordneten beheizten Substrathalter ein Substrat liegt, **dadurch gekennzeichnet, dass** zwei Reaktionsgase räumlich beabstandet voneinander und auf unterhalb ihrer Zerlegungstemperaturen gekühlt der Prozesskammer (1) zugeleitet werden, wobei die Temperatur am Ort des Zusammentreffens (51) der beiden Reaktionsgase in der Prozesskammer (1) höher ist, als die Sättigungstemperatur der Zerfallsprodukte bzw. möglicher Addukte der Zerfallsprodukte.

3. Vorrichtung nach Anspruch 1 oder Verfahren nach Anspruch 2, **dadurch gekennzeichnet, dass** auch die zweite Wand (4) der Prozesskammer (1) beheizbar ist bzw. beheizt wird.

4. Verfahren nach Anspruch 2, **dadurch gekennzeichnet, dass** die Prozesskammer auf über 1000°C, insbesondere über 1500°C aufgeheizt wird.

5. Vorrichtung nach einem der vorhergehenden Vorrichtungsansprüche, **dadurch gekennzeichnet, dass** der gekühlte Abschnitt (49) des Gaseinlassorgans (6) eine Kühlwasserkammer (28) aufweist.

6. Vorrichtung nach einem der vorhergehenden Vorrichtungsansprüche, **gekennzeichnet durch** einen ringförmigen Spalt (30) mit gekühlten Spaltwänden zum Austritt eines Reaktionsgases, welche Spaltwände aus Stahl bestehen und unmittelbar benachbart liegen zu einer über 1000°C, bevorzugt über 1500°C, aufheizbaren Graphit-Wandung der Prozesskammer.

7. Vorrichtung nach Anspruch 6, **dadurch gekennzeichnet, dass** der Keilspalt (30) über einen schmalen Ringspalt (37) mit einer Ringkammer (38) verbunden ist, in welche eine Zuleitung (27) mündet.

8. Vorrichtung nach einem der vorhergehenden Vorrichtungsansprüche, **gekennzeichnet durch** eine zentrale Zuleitung (26), die mittig aus dem in die Prozesskammer (1) ragenden Abschnitt (49) mündet.

9. Vorrichtung nach einem der vorhergehenden Vorrichtungsansprüche, **dadurch gekennzeichnet, dass** die Basisfläche (52) des in die Prozesskammer (1) ragenden kegelstumpfförmigen Abschnitt (49) etwa mittig, bevorzugt näher an der eine Trägerplatte (3) bildenden Wand, zwischen den beiden Wänden (3,4) liegt.

10. Vorrichtung nach Anspruch 9, **dadurch gekennzeichnet, dass** der kegelstumpfförmige Abschnitt (49) hohl ist und in der Höhlung Kühlwasserleitbleche (29) angeordnet sind.

11. Vorrichtung nach einem der vorhergehenden Vorrichtungsansprüche, **gekennzeichnet durch** einen mit der Wandung des Gaseinlassorgans (6) verbundenen Träger (33), insbesondere aus Graphit, welcher eine Tragschulter ausbildet, auf welcher eine ringförmige, beheizte Deckplatte (4) insbesondere aus Graphit aufliegt.

12. Vorrichtung nach Anspruch 11, **dadurch gekennzeichnet, dass** die Deckplatte (4) über sich durch gegenseitigen Untergriff tragenden Verkleidungsringen (34) liegt, wobei der innenliegende Ring mit seinem Rand auf einer Tragschulter liegt.

13. Vorrichtung nach Anspruch 12, **dadurch gekennzeichnet, dass** die Verkleidungsringe (34) aus TaC oder aus TaC- oder SiC- beschichtetem Graphit bestehen.

14. Vorrichtung nach einem der vorhergehenden Vorrichtungsanspüche, **dadurch gekennzeichnet, dass** die rückwärtig beheizte Wand (3) eine ringförmige Trägerplatte für mehrere, insbesondere drehbare Substrathalter (45) bildet.

15. Vorrichtung nach Anspruch 14, **dadurch gekennzeichnet, dass** die Trägerplatte (3) eine Ringform aufweist und von unten von einer zentralen Stützplatte (21) durch Randuntergriff getragen wird.

16. Vorrichtung nach Anspruch 15, **gekennzeichnet durch** eine über der Stützplatte (21) liegende Zugplatte (22), die sich auf dem Rand (3') der Trägerplatte (3) abstützt und an der eine Zugstange angreift.

## Claims

1. A device for depositing in particular crystalline layers on one or more, in particular likewise crystalline substrates in a process chamber (1) by means of reaction gases which are introduced into the process chamber where they react pyrolytically, the process chamber (1) having a first wall (3) and a second wall (4), which lies opposite the first, and at least one heated substrate holder (45) being associated with the first wall, at least one reaction gas being fed to the process chamber (1) by means of a fluid-cooled gas admission element (6), the gas admission element (6) having a base surface (52) which runs parallel to the first wall (3) and has an outlet opening (31), **characterized by** a base surface (52) on the rear of which cooling water impinges.

2. A method for depositing in particular crystalline layers on one or more, in particular likewise crystalline substrates in a process chamber (1) by means of reaction gases which are introduced into the process chamber (1) where they react pyrolytically, the process chamber having a first wall (3) and a second wall (4), which lies opposite the first, and a substrate lying on a heated substrate holder which is associated with the first wall, **characterized in that** two reaction gases, which are spatially at a spacing from one another and have been cooled to below their decomposition temperatures, are fed to the process chamber (1), the temperature at the location where the two reaction gases meet (51) in the process chamber (1) being higher than the saturation temperature of the decomposition products or possible adducts of the decomposition products.

3. A device according to Claim 1 or a method according to Claim 2, **characterized in that** the second wall (4) of the process chamber (1) is also heatable or is heated.

4. A method according to Claim 2, **characterized in that** the process chamber is heated up to over 1000°C, in particular over 1500°C.

5. A device according to one of the preceding device claims, **characterized in that** the cooled portion (49) of the gas admission element (6) has a cooling-water chamber (28).

6. A device according to one of the preceding device claims, **characterized by** an annular gap (30) with cooled gap walls for discharge of a reaction gas, which gap walls consist of steel and lie directly adjacent to a graphite wall, which can be heated up to over 1000°C, preferably over 1500°C, of the process chamber.

7. A device according to Claim 6, **characterized in that** the wedge gap (30) is connected via a narrow annular gap (37) to an annular chamber (38), into which a feed line (27) opens out.

8. A device according to one of the preceding device claims, **characterized by** a central feed line (26), which opens out centrally from the portion (49) projecting into the process chamber (1).

9. A device according to one of the preceding device claims, **characterized in that** base surface (52) of the frustoconical portion (49) which projects into the process chamber (1) is located approximately centrally, preferably closer to the wall forming a carrier plate (3), between the two walls (3, 4).

10. A device according to Claim 9, **characterized in that** the frustoconical portion (49) is hollow and cooling water guide plates (29) are disposed in the hollow.

11. A device according to one of the preceding device claims, **characterized by** a carrier (33) which is connected to the wall of the gas admission element (6), is made in particular from graphite and forms a supporting shoulder on which an annular, heated cover plate (4) in particular made from graphite rests.

12. A device according to Claim 11, **characterized in that** the cover plate (4) lies above lining rings (34) which support one another by engaging beneath one another, the edge of the inner ring resting on a supporting shoulder.

13. A device according to Claim 12, **characterized in that** the lining rings (34) consist of TaC or of TaC- or SiC-coated graphite.

14. A device according to one of the preceding device claims, **characterized in that** the rearwardly-heated wall (3) forms an annular carrier plate for a plurality of in particular rotatable substrate holders (45).

15. A device according to Claim 14, **characterized in that** the carrier plate (3) is in the shape of a ring and is supported from below by a central support plate (21) as a result of the edge of the latter engaging beneath it.

16. A device according to Claim 15, **characterized by** a tension plate (22) which lies above the support plate (21), is supported on the edge (3') of the carrier plate (3) and on which a tie rod acts.

## Revendications

1. Dispositif de dépôt de couches, notamment cristallines, sur un ou plusieurs substrats, notamment également cristallins, dans une chambre de réaction (1) au moyen de gaz de réaction introduits dans la chambre de réaction dans laquelle ils subissent une transformation pyrolytique, la chambre de réaction (1) possédant une première paroi (3) et une deuxième paroi (4), opposée à la première paroi, et la première paroi étant associée à au moins un porte-substrat chauffé (45), au moins un gaz de réaction étant amené à la chambre de réaction (1) au moyen d'un organe d'admission de gaz (6) refroidi par liquide, l'organe d'admission de gaz (6) présentant une surface de base (52) qui s'étend parallèlement à la première paroi (3) et qui est dotée d'une ouverture de sortie (31), **caractérisé en ce que** la surface de base (52) est alimentée à l'arrière en eau de refroidissement.

2. Procédé de dépôt de couches, notamment cristallines, sur un ou plusieurs substrats, notamment également cristallins, dans une chambre de réaction (1) au moyen de gaz de réaction introduits dans la chambre de réaction (1) dans laquelle ils subissent une transformation pyrolytique, la chambre de réaction possédant une première paroi (3) et une deuxième paroi (4), opposée à la première paroi, et un substrat étant placé sur un porte-substrat chauffé associé à la première paroi, **caractérisé en ce que** deux gaz de réaction sont, spatialement, amenés séparément à la chambre de réaction (1) en étant refroidis à une température inférieure à leur température de décomposition, la température au point de rencontre (51) des deux gaz de réaction dans la chambre de réaction (1) étant supérieure à la température de saturation des produits de décomposition respectivement des éventuels produits d'addition des produits de décomposition.

3. Dispositif selon la revendication 1 ou procédé selon la revendication 2, **caractérisé en ce que** la deuxième paroi (4) de la chambre de réaction (1) est également chauffée respectivement peut également être chauffée.

4. Procédé selon la revendication 2, **caractérisé en ce que** la chambre de réaction est chauffée à une température supérieure à 1000°C, notamment supérieure à 1500°C.

5. Dispositif selon l'une des revendications de dispositif précédentes, **caractérisé en ce que** la portion refroidie (49) de l'organe d'admission de gaz (6) comporte une chambre d'eau de refroidissement (28).

6. Dispositif selon l'une des revendications de dispositif précédentes, **caractérisé par** une fente annulaire (30) dont les parois de fente sont refroidies et qui est destinée à la sortie d'un gaz de réaction, lesdites parois de fente étant en acier et situées au voisinage immédiat d'une paroi en graphite de la chambre de réaction qui peut être chauffée à une température supérieure à 1000°C, de préférence supérieure à 1500°C.

7. Dispositif selon la revendication 6, **caractérisé en ce que** la fente conique (30) est reliée par une fente annulaire étroite (37) à une chambre annulaire (38) dans laquelle débouche une conduite d'amenée (27).

8. Dispositif selon l'une des revendications de dispositif précédentes, **caractérisé par** une conduite d'amenée centrale (26) qui débouche centralement de la portion (49) saillant dans la chambre de réaction (1).

9. Dispositif selon l'une des revendications de dispositif précédentes, **caractérisé en ce que** la surface de base (52) de la portion tronconique (49) saillant dans la chambre de réaction (1) est placée à peu près au milieu, de préférence plus près de la paroi formant une plaque de support (3), entre les deux parois (3, 4).

10. Dispositif selon la revendication 9, **caractérisé en ce que** la portion tronconique (49) est creuse et des tôles de guidage d'eau refroidissement (29) sont disposées dans le creux.

11. Dispositif selon l'une des revendications de dispositif précédentes, **caractérisé par** un support (33), notamment en graphite, qui est relié à la paroi de l'organe d'admission de gaz (6) et qui forme un épaulement de support sur lequel repose une plaque de recouvrement annulaire (4), notamment en graphite, qui est chauffée.

12. Dispositif selon la revendication 11, **caractérisé en ce que** la plaque de recouvrement (4) repose sur des bagues de garnissage (34) qui sont supportées par un griffe inférieure opposée, la bague intérieure portant au niveau de son bord sur un épaulement de support.

13. Dispositif selon la revendication 12, **caractérisé en ce que** les bagues de garnissage (34) sont en en TaC ou en graphite revêtu d'une couche de TaC ou de de SiC.

14. Dispositif selon l'une des revendications de dispositif précédentes, **caractérisé en ce que** la paroi (3) chauffée à l'arrière forme une plaque de support annulaire destinée à plusieurs porte-substrats (45), notamment rotatifs.

15. Dispositif selon la revendication 14, **caractérisé en ce que** la plaque de support (3) a une forme annulaire et est supportée par au-dessous par une plaque de support centrale (21) par l'intermédiaire d'un griffe de bordure inférieure.

16. Dispositif selon la revendication 15, **caractérisé par** une plaque de traction (22) qui repose sur la plaque de support (21), qui s'appuie sur le bord (3') la plaque de support (3) et qui s'engage avec l'une des barres de traction.
